# EUROPEAN PATENT APPLICATION

(11) **EP 4 462 969 A1**
(43) Date of publication of application: **13.11.2024**
(21) Application number: 24175042.1
(22) Date of filing: 09.05.2024
(51) Int. Cl.: H05K 7/20

(54) **SYSTEMS, DEVICES, AND METHODS FOR IMPROVING HEAT DISSIPATION**

(30) Priority: 10.05.2023 IN 202321033033
(71) Applicant: Vertiv Corporation, Westerville, OH 43082 (US)
(72) Inventor: NATARAJAN, Srinivasan, 638501 Erode, Tmil Nadu (IN); PAITHANE, Manoj, 411036 Pune, Maharashtra (IN); CHARAPALE, Utkarsh Diliprao, 416114 Kolhapur, Mararashtra (IN); SURVASE, Tushar, 411033 Pune, Mararashtra (IN)
(74) Representative: Bryn-Jacobsen, Caelia

(57) **Abstract**

A system for heat dissipation in an electronic equipment housing having a heat generating device therein can include a fan configured to induce air flow through the housing, a heat sink thermally coupled to the heat generating device, and a diverter positioned to direct at least a portion of the air flow into the heat sink.

## Description

### CROSS-REFERENCE TO RELATED APPLICATIONS

This application claims the benefit of Indian Provisional Patent Application No. 202321033033 filed May 10, 2023,.

### BACKGROUND OF THE INVENTION

Field of the Invention. The present disclosure relates generally to electronic equipment cabinets and more specifically relates to heat dissipation in electronic equipment cabinets.

Description of the Related Art. Typical electronic equipment includes internal components that generate significant heat, and therefore have fans to draw cooling air through their housings. For example, typical rack mounted computer equipment includes central processing units (CPUs) and/or graphics processing units (GPUs). Particularly hot, and/or heat sensitive, devices may have heat sinks to better dissipate heat. However, cooling air may only thermally couple with a portion of these heat sinks and/or a portion of the cooling air may disperse or otherwise traverse the housing without thermally coupling with a heat sink, thereby leading to inefficiencies.

### SUMMARY OF THE INVENTION

Applicants have created new and useful devices, systems and methods for improving heat dissipation. In at least one example, a system for improved heat dissipation can include an electronic equipment housing having a heat generating device therein, a fan configured to induce air flow through the housing, a heat sink thermally coupled to the heat generating device, and a diverter positioned to direct at least a portion of the air flow into the heat sink. In at least one example, the diverter can be V-shaped and/or have a V-shaped cross-section. In at least one example, the diverter can be vertically or horizontally oriented. In at least one example, the diverter can be oriented at an angle with respect to a vertical and/or horizontal axis of the housing.

In at least one example, a system for improved heat dissipation can include a second heat generating device within the housing and a second heat sink thermally coupled to the second heat generating device. In at least one example, the diverter can also direct at least a second portion of the air flow into the second heat sink.

In at least one example, a system for improved heat dissipation can include a second and/or third diverter positioned between the first heat sink and the second heat sink. In at least one example, the first diverter can be positioned upstream, in the air flow, from the second diverter. In at least one example, the second diverter can be positioned upstream, in the air flow, from the third diverter. In at least one example, the second diverter can be longer than the first diverter. In at least one example, the third diverter can be longer than the second diverter.

In at least one example, the second diverter can be configured to direct at least a third portion of the air flow into the first heat sink and direct at least a fourth portion of the air flow into the second heat sink. In at least one example, the second diverter can be configured to direct the first portion of the air flow along the first heat sink. In at least one example, the third diverter can be configured to direct the second portion of the air flow along the second heat sink.

In at least one example, a system for improved heat dissipation can include a second heat sink thermally coupled to the first heat generating device. In at least one example, a system for improved heat dissipation can include a second heat generating device within the housing, with a third heat sink thermally coupled to the second heat generating device and/or a fourth heat sink thermally coupled to the second heat generating device. In at least one example, the first diverter can be configured to also direct at least a second portion of the air flow into the third heat sink.

In at least one example, a system for improved heat dissipation can include a second diverter positioned between the first heat sink and the third heat sink. In at least one example, a system for improved heat dissipation can include a third diverter configured to direct at least a third portion of the air flow into the second heat sink. In at least one example, a system for improved heat dissipation can include a fourth diverter configured to direct at least a fourth portion of the air flow into the fourth heat sink.

### BRIEF DESCRIPTION OF DRAWINGS

FIG. 1 is a perspective view of one of many electronic equipment modules that can benefit from the present disclosure.
FIG. 2 is a temperature distribution map of a portion of the module of FIG. 1.
FIG. 3 is an air velocity distribution map of the module of FIG. 1.
FIG. 4 is a perspective view of one of many examples of an air flow diverter arrangement according to the disclosure.
FIG. 5 is a cut-away plan view of one of many examples of a system for improved heat dissipation according to the disclosure.
FIG. 6 is a temperature distribution map of a portion of the system of FIG. 5.
FIG. 7 is an air velocity distribution map of the system of FIG. 5.
FIG. 8 is a perspective view of one of many examples of an air flow diverter according to the disclosure.
FIG. 9 is a cut-away perspective view of another one of many examples of a system for improved heat dissipation according to the disclosure.
FIG. 10 is a cut-away perspective view of the system of FIG. 9, showing air flow therethrough.
FIG. 11 is a temperature distribution map of a portion of the system of FIG. 9.
FIG. 12 is an air velocity distribution map of a portion of the system of FIG. 9.
FIG. 13 is a perspective view of one of many examples of an air flow diverter arrangement according to the disclosure.
FIG. 14 is a cut-away perspective view of still another one of many examples of a system for improved heat dissipation according to the disclosure.
FIG. 15 is a cut-away perspective view of the system of FIG. 14, showing air flow therethrough.
FIG. 16 is a temperature distribution map of a portion of the system of FIG. 14.
FIG. 17 is an air velocity distribution map of a portion of the system of FIG. 14.
FIG. 18 is a perspective view of another one of many examples of an air flow diverter arrangement according to the disclosure.
FIG. 19 is a cut-away plan view of yet another one of many examples of a system for improved heat dissipation according to the disclosure.
FIG. 20 is a temperature distribution map of a portion of the system of FIG. 19.
FIG. 21 is an air velocity distribution map of a portion of the system of FIG. 19.
FIG. 22 is a perspective view of another one of many examples of an air flow diverter and heat sink arrangement according to the disclosure.
FIG. 23 is a cut-away perspective view of another one of many examples of a system for improved heat dissipation according to the disclosure.
FIG. 24 is a cut-away perspective view of the system of FIG. 23, showing air flow therethrough.
FIG. 25 is a temperature distribution map of a portion of the system of FIG. 23.
FIG. 26 is an air velocity distribution map of a portion of the system of FIG. 23.
FIG. 27 is a cut-away perspective view of yet another one of many examples of a system for improved heat dissipation according to the disclosure.
FIG. 28 is a perspective view of select components of the system of FIG. 27.
FIG. 29 is a cut-away perspective view of the system of FIG. 27, showing air flow therethrough.

### DETAILED DESCRIPTION OF THE INVENTION

The figures described above and the written description of specific structures and functions below are not presented to limit the scope of what Applicants have invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicants have created new and useful devices, systems and methods for improving heat dissipation. In at least one example, a system for improved heat dissipation can include an electronic equipment housing having one or more heat generating device(s) therein, at least one fan configured to induce airflow through the housing, one or more heat sink(s) thermally coupled to the heat generating device(s), and at least one diverter positioned to direct at least a portion of the air flow into or otherwise relative to the heat sink(s) for supporting efficient and effective heat transfer.

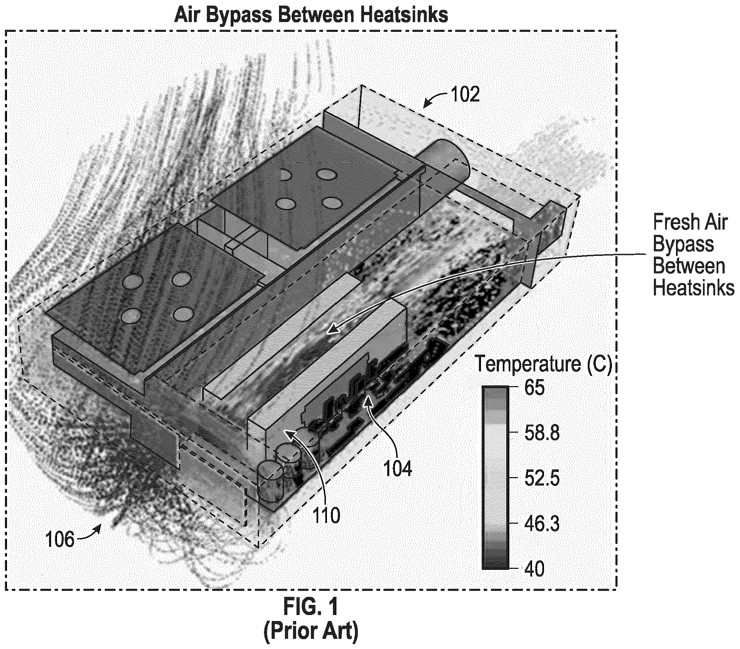

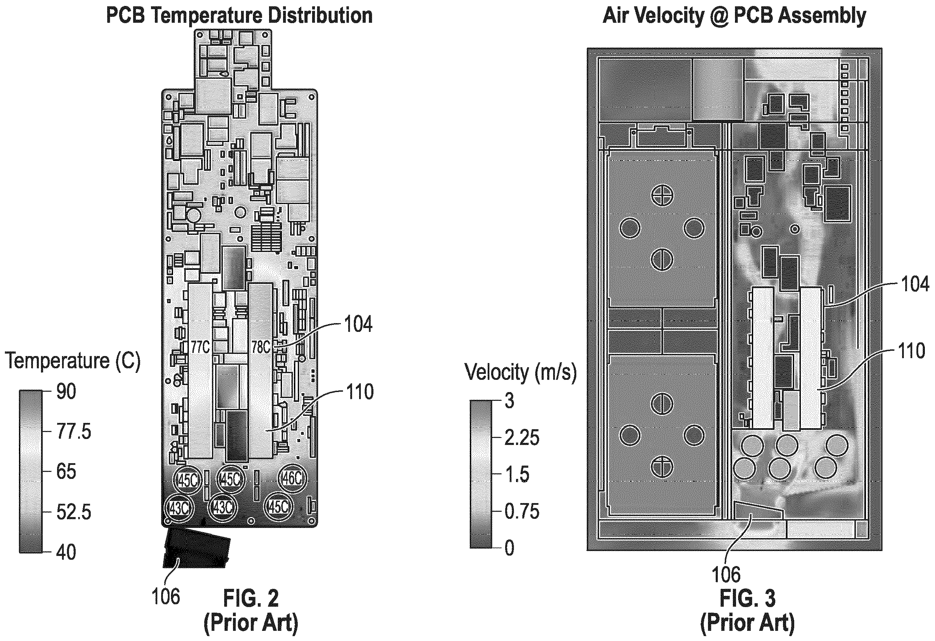

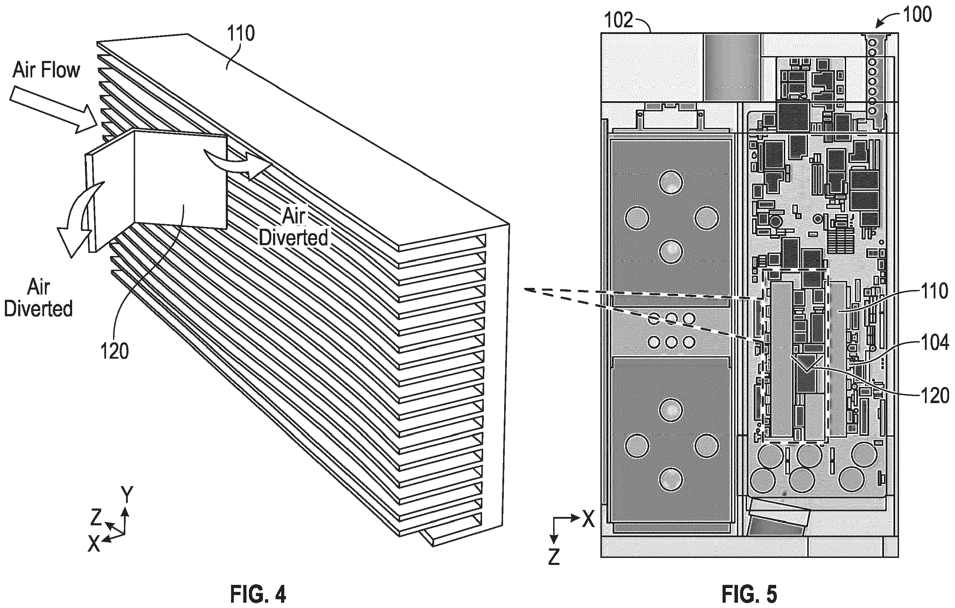

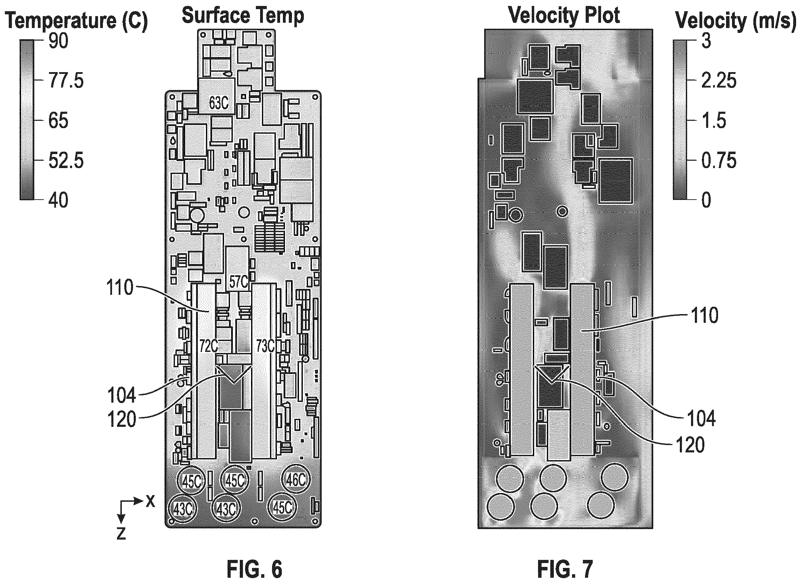

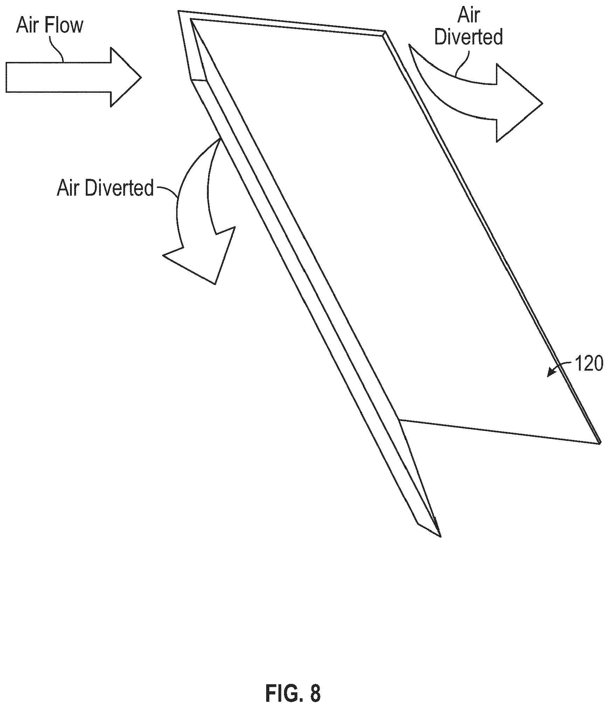

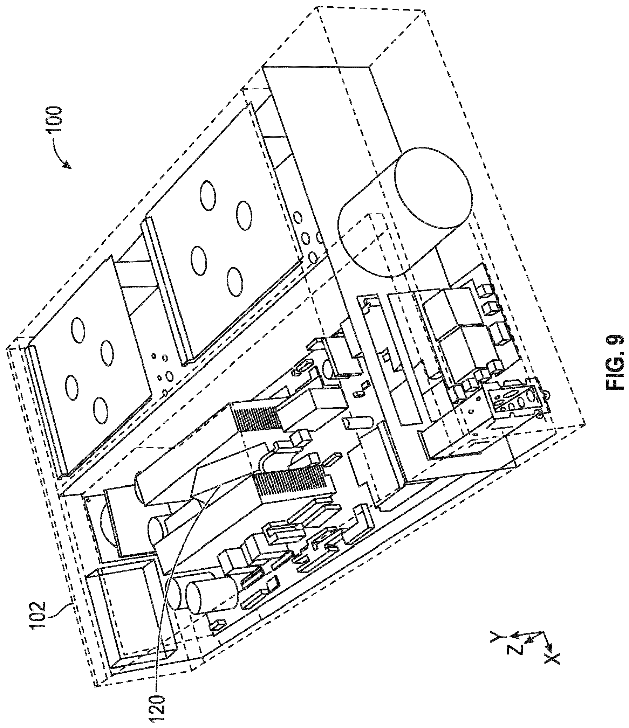

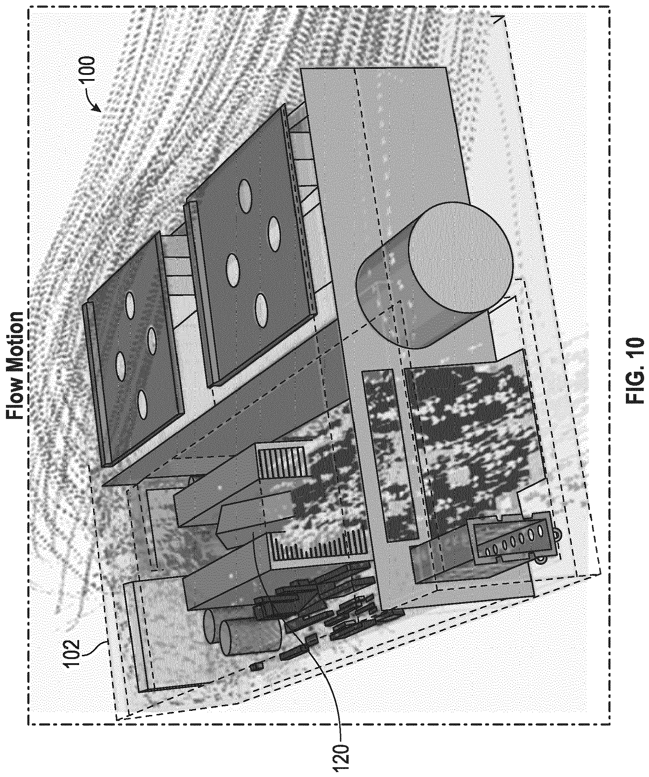

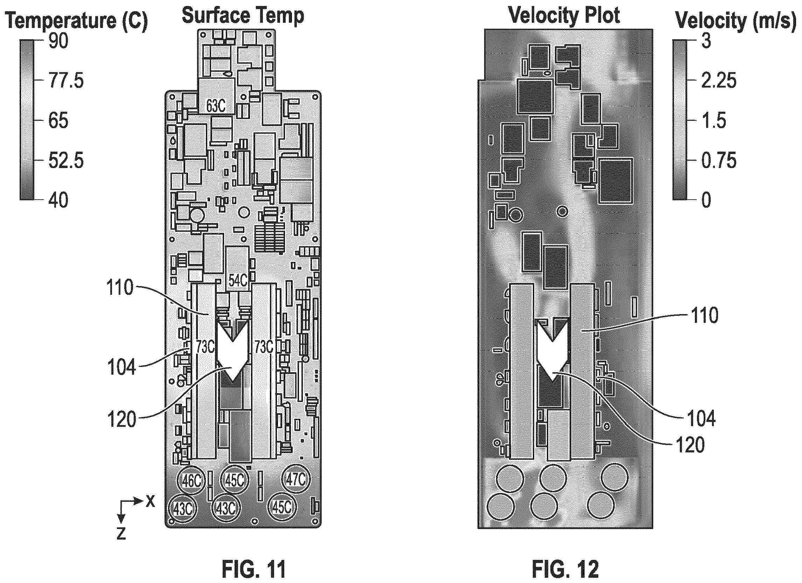

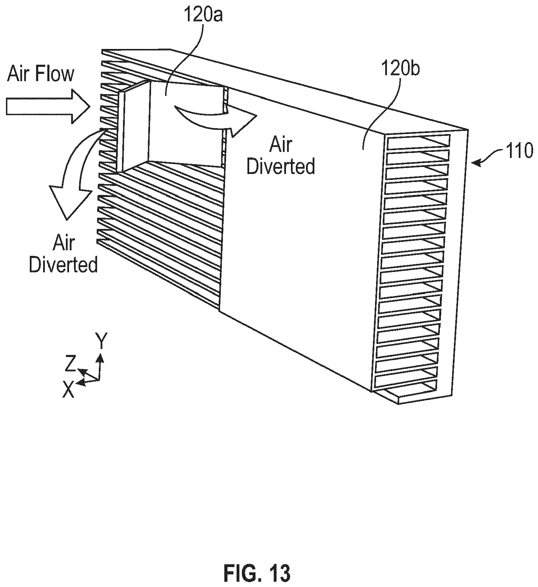

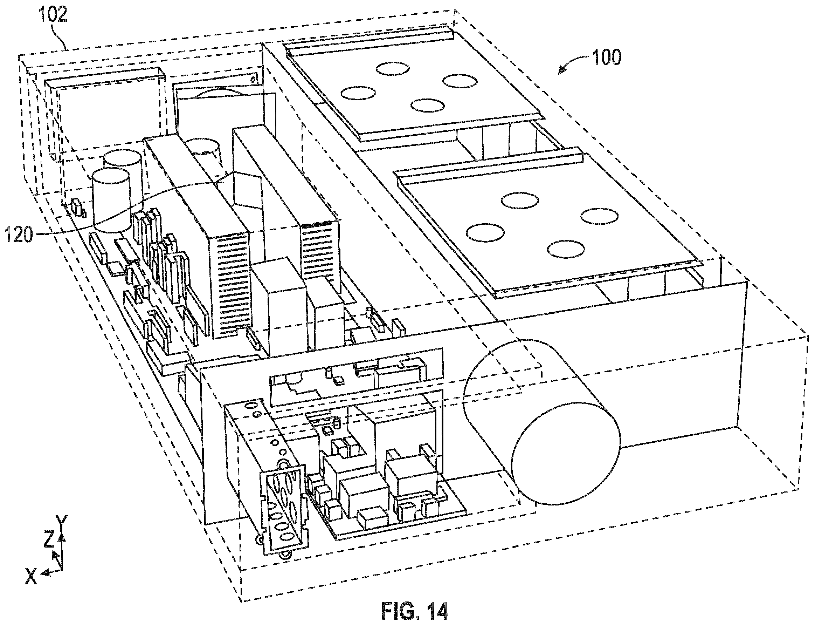

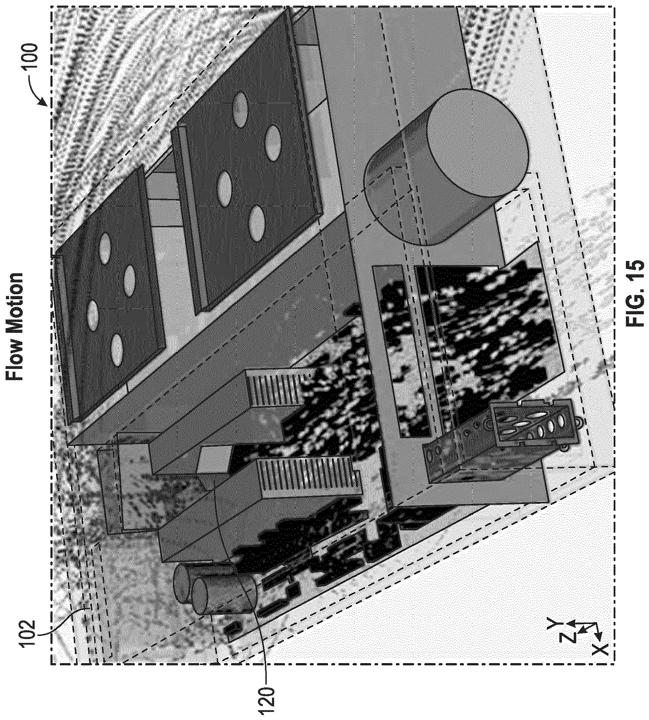

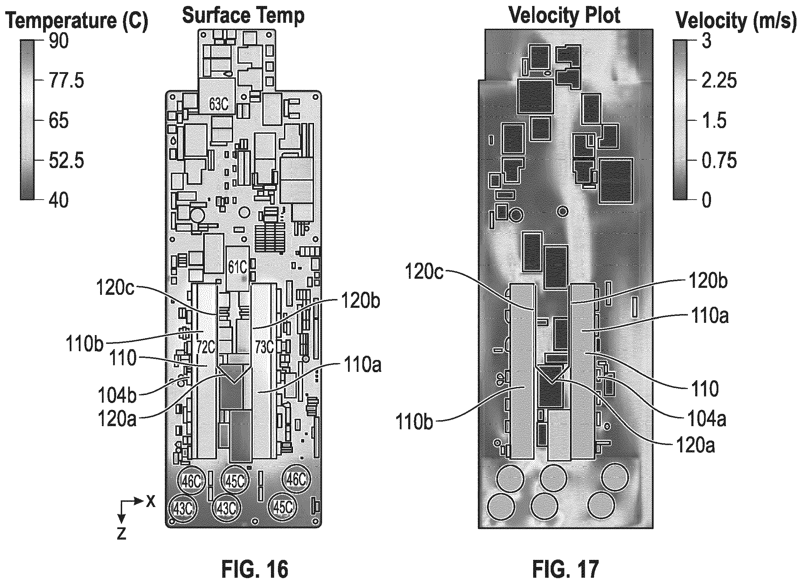

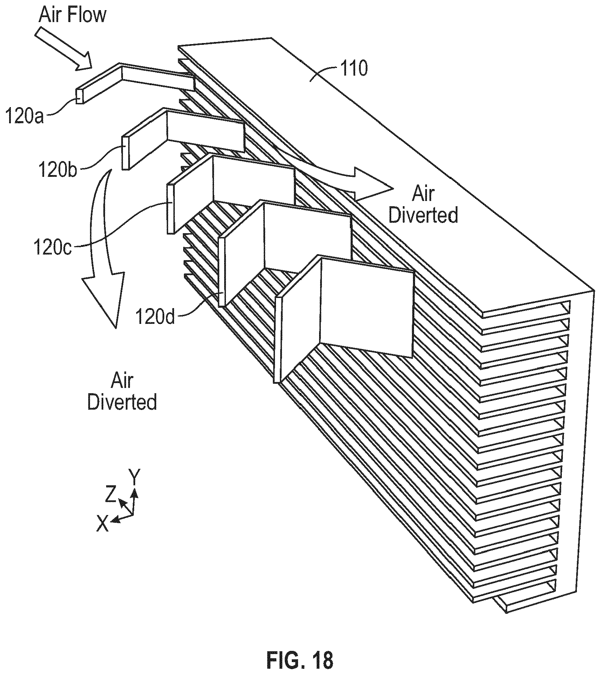

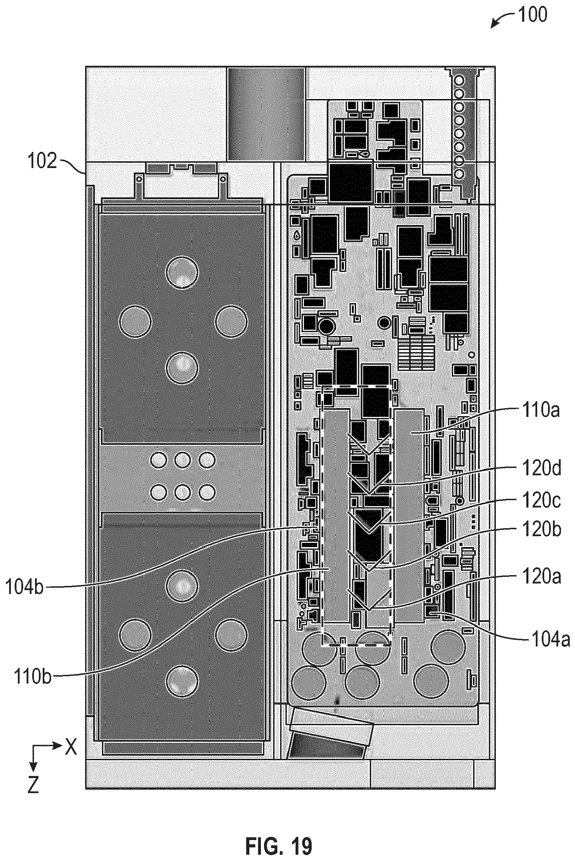

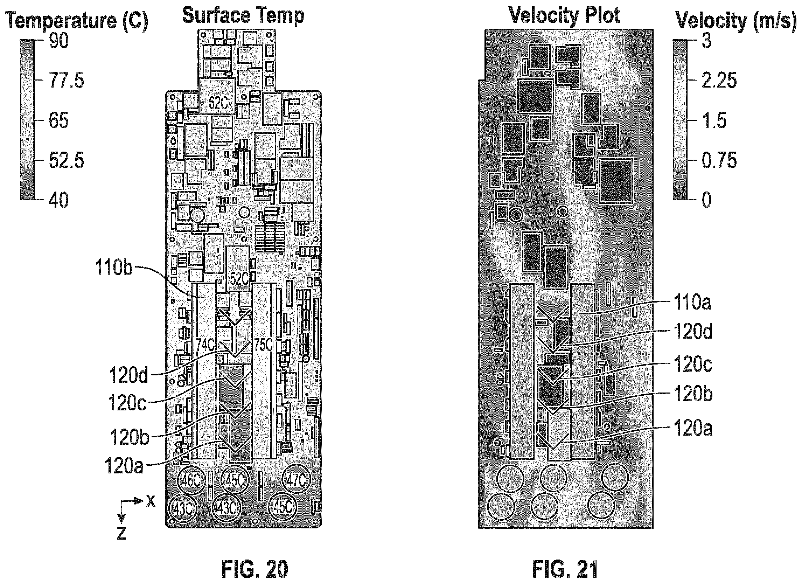

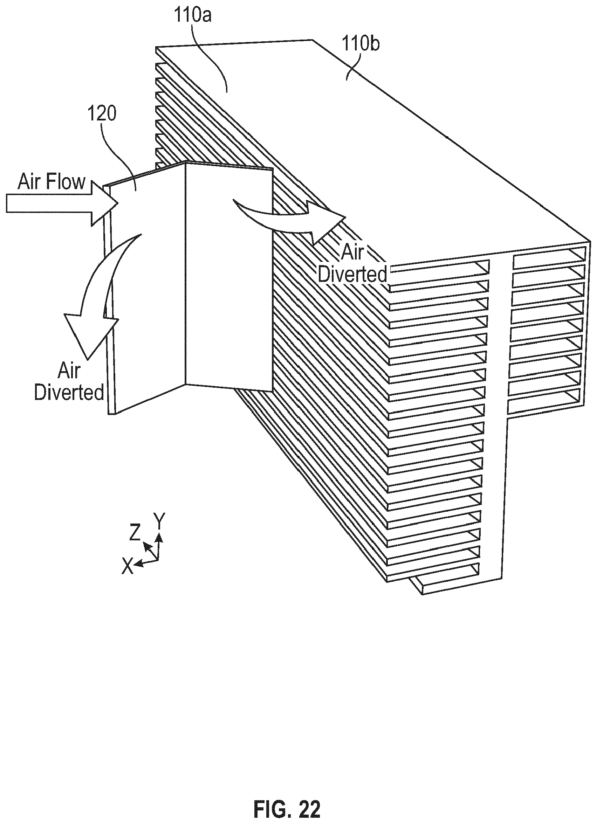

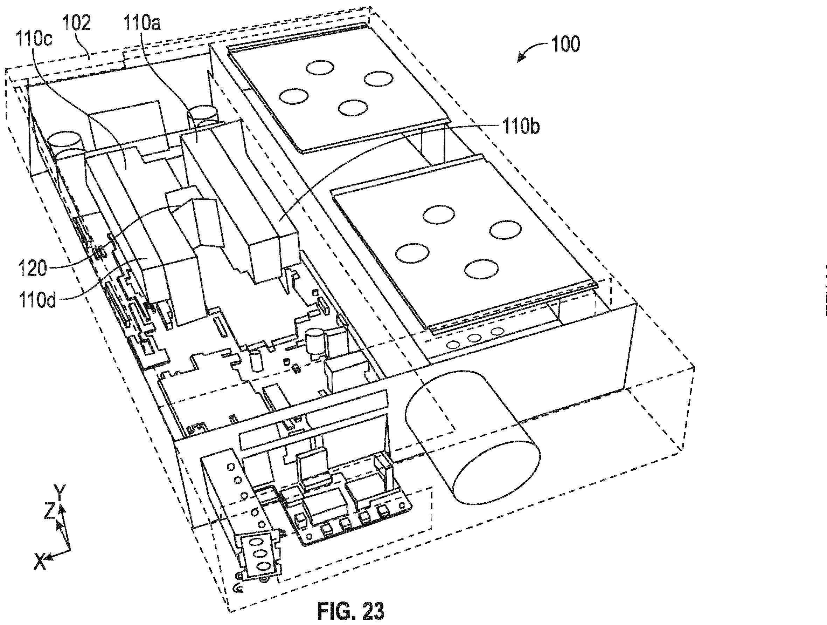

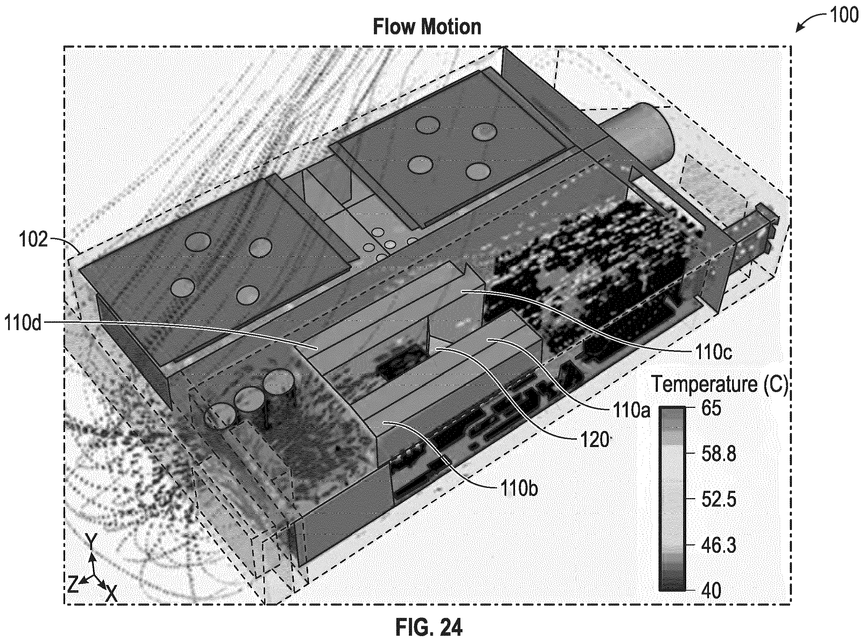

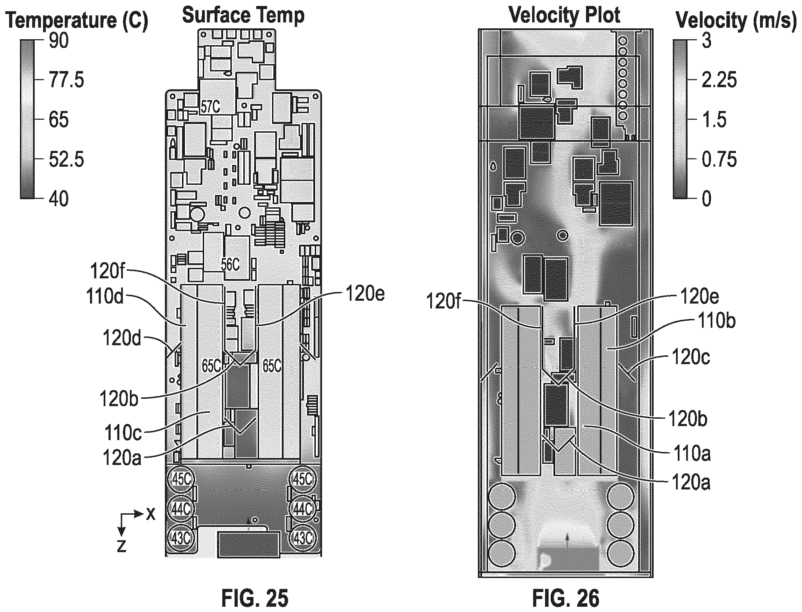

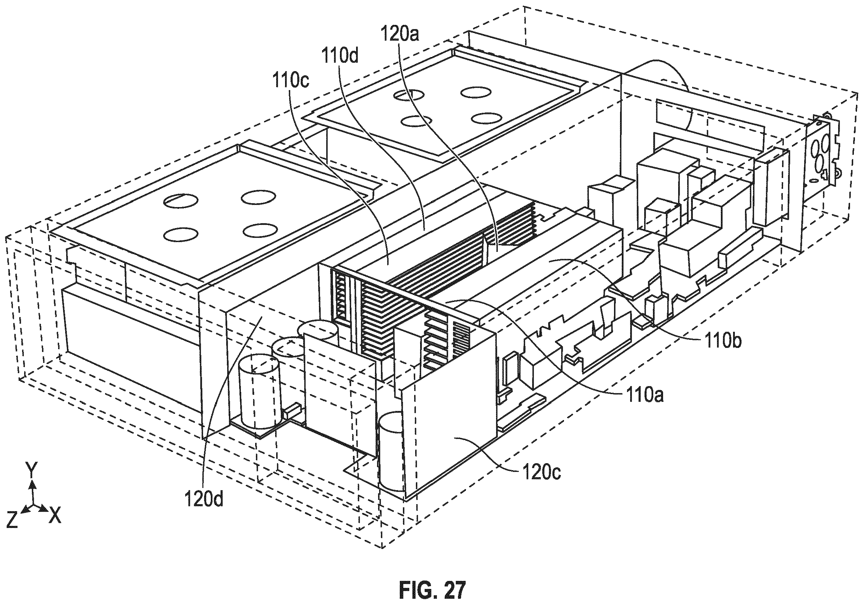

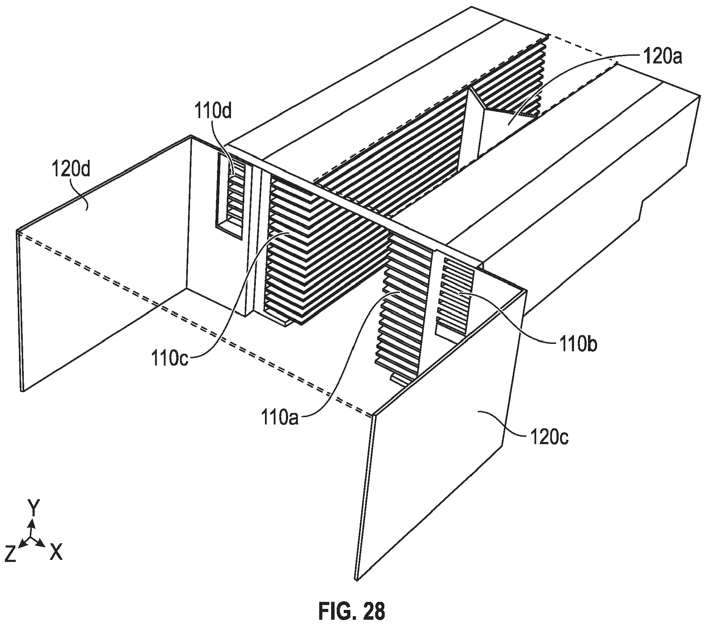

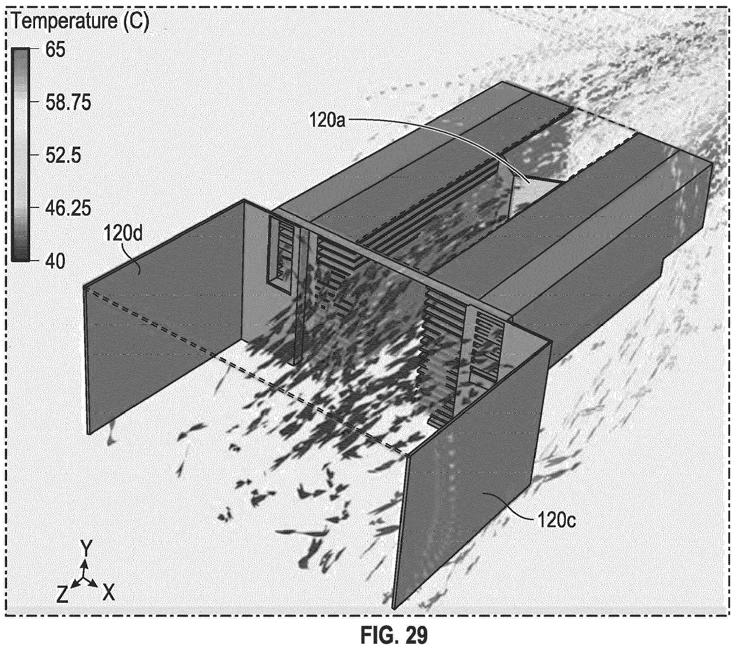

FIG. 1 is a perspective view of one of many electronic equipment modules that can benefit from the present disclosure. FIG. 2 is a temperature distribution map of a portion of the module of FIG. 1. FIG. 3 is an air velocity distribution map of the module of FIG. 1. FIG. 4 is a perspective view of one of many examples of an air flow diverter arrangement according to the disclosure. FIG. 5 is a cut-away plan view of one of many examples of a system for improved heat dissipation according to the disclosure. FIG. 6 is a temperature distribution map of a portion of the system of FIG. 5. FIG. 7 is an air velocity distribution map of the system of FIG. 5. FIG. 8 is a perspective view of one of many examples of an air flow diverter according to the disclosure. FIG. 9 is a cut-away perspective view of another one of many examples of a system for improved heat dissipation according to the disclosure. FIG. 10 is a cut-away perspective view of the system of FIG. 9, showing air flow therethrough. FIG. 11 is a temperature distribution map of a portion of the system of FIG. 9. FIG. 12 is an air velocity distribution map of a portion of the system of FIG. 9. FIG. 13 is a perspective view of one of many examples of an air flow diverter arrangement according to the disclosure. FIG. 14 is a cut-away perspective view of still another one of many examples of a system for improved heat dissipation according to the disclosure. FIG. 15 is a cut-away perspective view of the system of FIG. 14, showing air flow therethrough. FIG. 16 is a temperature distribution map of a portion of the system of FIG. 14. FIG. 17 is an air velocity distribution map of a portion of the system of FIG. 14. FIG. 18 is a perspective view of another one of many examples of an air flow diverter arrangement according to the disclosure. FIG. 19 is a cut-away plan view of yet another one of many examples of a system for improved heat dissipation according to the disclosure. FIG. 20 is a temperature distribution map of a portion of the system of FIG. 19. FIG. 21 is an air velocity distribution map of a portion of the system of FIG. 19. FIG. 22 is a perspective view of another one of many examples of an air flow diverter and heat sink arrangement according to the disclosure. FIG. 23 is a cut-away perspective view of another one of many examples of a system for improved heat dissipation according to the disclosure. FIG. 24 is a cut-away perspective view of the system of FIG. 23, showing air flow therethrough. FIG. 25 is a temperature distribution map of a portion of the system of FIG. 23. FIG. 26 is an air velocity distribution map of a portion of the system of FIG. 23. FIG. 27 is a cut-away perspective view of yet another one of many examples of a system for improved heat dissipation according to the disclosure. FIG. 28 is a perspective view of select components of the system of FIG. 27. FIG. 29 is a cut-away perspective view of the system of FIG. 27, showing air flow therethrough. FIGS. 1-29 are described in conjunction with one another.

In at least one example, a system according to the disclosure, such as a system 100 for improved heat dissipation, can include one or more electronic equipment housings 102 having one or more heat generating devices 104 therein, one or more fans 106 configured to induce air flow through the housing 102, one or more heat sinks 110 thermally coupled to the heat generating device 104, and one or more diverters 120 positioned to direct at least a portion of the air flow into or towards thermal communication with one or more of the heat sinks 110 or a portion(s) thereof. For example, one or more diverters 120 can be advantageously shaped and arranged relative to one or more heat sinks 110 for biasing air flow into channels between fins of a heat sink 110 or otherwise towards heat transfer surfaces of a heat sink 110 for supporting efficient and effective heat transfer or cooling performance. In at least one example, the housing 102 can include a rack mounted system, such as for use with rack mounted computer and/or power equipment, such as a server or an uninterruptible power supply (UPS). In at least one example, the heat generating device 104 can be a central processing unit (CPU), a graphics processing unit (GPU), an insulated-gate bipolar transistor (IGBT), a field effect transistor (FET), another heat generating device, or any combination thereof. In at least one example, one heat sink 110 can be thermally coupled to multiple heat generating devices 104, multiple heat sinks 110 can be thermally coupled to one heat generating device 104, or any combination thereof. For example, one heat sink 110 can be thermally coupled to multiple heat generating devices 104, while another heat sink 110 is thermally coupled to some of those heat generating devices 104.

In at least one example, the diverter 120 can be V-shaped and/or have a V-shaped cross-section. In at least one example, the diverter 120 can present a 120-degree angle. In at least one example, the diverter 120 can present a 90-degree angle. In at least one example, the diverter 120 can present a 60-degree angle. In at least one example, the diverter 120 can present any angle between 0 and 180 degrees. In at least one example, the diverter 120 can be another shape, such as L-shaped, flat, or rounded.

In at least one example, the diverter 120 can be vertically or horizontally oriented. In at least one example, the diverter 120 can be oriented at an angle with respect to a vertical and/or horizontal axis of the housing 102. In at least one example, the diverter 120 can be thermally conductive and thereby provide some heat sink/dissipation itself. In at least one example, the diverter 120 can be electrically insulative. In at least one example, the diverter 120 can be made of metal or plastic.

In at least one example, a system 100 for improved heat dissipation can include multiple diverters 120. In at least one example, one diverter 120 can direct at least a portion of the air flow into multiple heat sinks 110, multiple diverters 120 can direct at least a portion of the air flow into the same heat sink 110, or any combination thereof. For example, one diverter 120 can direct at least a portion of the air flow into multiple heat sinks 110, while another diverter 120 directs at least a portion of the air flow into one or more of those heat sinks 110.

In at least one example, a system 100 for improved heat dissipation can include a first heat generating device 104a within the housing 102 and a first heat sink 110a thermally coupled to the first heat generating device 104a, a second heat generating device 104b within the housing 102 and a second heat sink 110b thermally coupled to the second heat generating device 104b, a first diverter 120a positioned between the first heat sink 110a and the second heat sink 110b, or any combination thereof. In at least one example, the first diverter 120a can direct at least a first portion of the air flow into the first heat sink 110a and at least a second portion of the air flow into the second heat sink 110b.

In at least one example, a system 100 for improved heat dissipation can include a second and/or third diverter 120b, 120c positioned between the first heat sink 110a and the second heat sink 110b. In at least one example, the first diverter 120a can be positioned upstream or downstream, in the air flow, from the second diverter 120b. In at least one example, the second diverter 120b can be positioned upstream or downstream, in the air flow, from the third diverter 120c. In at least one example, one diverter 120 can be positioned adjacent to (and/or at essentially the same position in the air flow as) another diverter 120.

In at least one example, the second diverter 120b can be longer or shorter than the first diverter 120a. In at least one example, the third diverter 120c can be longer or shorter than the second diverter 120b. In at least one example, one diverter 120 can be essentially the same length as another diverter 120. In at least one example, one diverter 120 can be positioned at an angle with respect to another diverter 120. In at least one example, one diverter 120 can be different than another diverter 120. For example, one diverter 120 can be configured to channel air into a heat sink 110, and another diverter can be configured to retain air within that, or another, heat sink 110. In at least one example, the second diverter 120b can be configured to direct the first portion of the air flow along the first heat sink 110a. In at least one example, the third diverter 120c can be configured to direct the second portion of the air flow along the second heat sink 110b.

In at least one example, the second diverter 120b can be configured to direct at least a third portion of the air flow into the first heat sink 110a and direct at least a fourth portion of the air flow into the second heat sink 110b. For example, downstream of the first diverter 120 the air flow that was diverted into the first and/or second heat sinks 110a, 110b may begin to escape those heat sinks 110a, 110b. Thus, a second diverter 120b positioned downstream from the first diverter 120 can redivert all or a portion of the air flow that was diverted into the first and/or second heat sinks 110a, 110b by the first diverter 120a. In at least one example, a second diverter 120b positioned downstream from the first diverter 120 can divert even more of the air flow that was diverted into the first and/or second heat sinks 110a, 110b by the first diverter 120a.

In at least one example, a system 100 for improved heat dissipation can include a first heat sink 110a and a second heat sink 110b thermally coupled to the first heat generating device 104a. In at least one example, a system 100 for improved heat dissipation can include a second heat generating device 104b within the housing 102, with a third heat sink 110c thermally coupled to the second heat generating device 104b and/or a fourth heat sink 110d thermally coupled to the second heat generating device 104b. In at least one example, a first diverter 120a can be configured to direct at least a first portion of the air flow into the first heat sink 110a and/or direct at least a second portion of the air flow into the third heat sink 110c.

In at least one example, a system 100 for improved heat dissipation can include a second diverter 120b positioned between the first heat sink 110a and the third heat sink 110c. In at least one example, a system 100 for improved heat dissipation can include a third diverter 120c configured to direct at least a third portion of the air flow into the second heat sink 110b and/or the first heat sink 110a. In at least one example, a system 100 for improved heat dissipation can include a fourth diverter 120d configured to direct at least a fourth portion of the air flow into the fourth heat sink 110d and/or the third heat sink 110c. In at least one example, a system 100 for improved heat dissipation can include a fifth diverter 120e configured to retain the first portion of the air flow within the first heat sink 110a. In at least one example, a system 100 for improved heat dissipation can include a sixth diverter 120f configured to retain the second portion of the air flow within the third heat sink 110c. In at least one example, a system 100 for improved heat dissipation can include any one or more, including all, of the heat sinks 110 and/or diverters 120 described herein.

In at least one example, a diverter 120 can be or include one or more plates for supporting the diversion or channeling of air into or through one or more heat sinks 110 or portions thereof. As shown in FIGS. 28 and 29, for example, diverter 120d can be one or more plates for channeling air into both the fourth heat sink 110d and the third heat sink 110c. As shown in FIGS. 25 and 26, for example, diverter 120e can be one or more plates for retaining, or rediverting, air into heat sink 110a. As also shown in FIGS. 25 and 26, for example, diverter 120a and/or diverter 120b can be one or more plates for channeling air into both the first heat sink 110a and the third heat sink 110c.

In at least one example, a system for improved heat dissipation can include an electronic equipment housing having a heat generating device therein, a fan configured to induce air flow through the housing, a heat sink thermally coupled to the heat generating device, and a diverter positioned to direct at least a portion of the air flow into the heat sink. In at least one example, the diverter can be V-shaped and/or have a V-shaped cross-section. In at least one example, the diverter can be vertically or horizontally oriented. In at least one example, the diverter can be oriented at an angle with respect to a vertical and/or horizontal axis of the housing.

In at least one example, a system for improved heat dissipation can include a second heat generating device within the housing and a second heat sink thermally coupled to the second heat generating device. In at least one example, the diverter can also direct at least a second portion of the air flow into the second heat sink.

In at least one example, a system for improved heat dissipation can include a second and/or third diverter positioned between the first heat sink and the second heat sink. In at least one example, the first diverter can be positioned upstream, in the air flow, from the second diverter. In at least one example, the second diverter can be positioned upstream, in the air flow, from the third diverter. In at least one example, the second diverter can be longer than the first diverter. In at least one example, the third diverter can be longer than the second diverter.

In at least one example, the second diverter can be configured to direct at least a third portion of the air flow into the first heat sink and direct at least a fourth portion of the air flow into the second heat sink. In at least one example, the second diverter can be configured to direct the first portion of the air flow along the first heat sink. In at least one example, the third diverter can be configured to direct the second portion of the air flow along the second heat sink.

In at least one example, a system for improved heat dissipation can include a second heat sink thermally coupled to the first heat generating device. In at least one example, a system for improved heat dissipation can include a second heat generating device within the housing, with a third heat sink thermally coupled to the second heat generating device and/or a fourth heat sink thermally coupled to the second heat generating device. In at least one example, the first diverter can be configured to also direct at least a second portion of the air flow into the third heat sink.

In at least one example, a system for improved heat dissipation can include a second diverter positioned between the first heat sink and the third heat sink. In at least one example, a system for improved heat dissipation can include a third diverter configured to direct at least a third portion of the air flow into the second heat sink. In at least one example, a system for improved heat dissipation can include a fourth diverter configured to direct at least a fourth portion of the air flow into the fourth heat sink.

Other and further examples utilizing one or more aspects of the disclosure can be devised without departing from the spirit of Applicants' disclosure. For example, the devices, systems and methods can be implemented for numerous different types and sizes in numerous different industries. Further, the various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

Further examples are set out in the clauses below:
1. A system comprising: an electronic equipment housing having a first heat generating device therein; a fan configured to induce air flow through the housing; a first heat sink thermally coupled to the first heat generating device; and a first diverter positioned to direct at least a first portion of the air flow into the first heat sink.
2. The system of clause 1, further comprising a second heat generating device within the housing and a second heat sink thermally coupled to the second heat generating device, and wherein the first diverter is configured to also direct at least a second portion of the air flow into the second heat sink.
3. The system of clause 1 or 2, wherein the first diverter is V-shaped.
4. The system of any one of clauses 1-3, wherein the first diverter has a V-shaped cross-section.
5. The system of clause any one of clauses 1-4, wherein the first diverter is vertically oriented.
6. The system of any one of clauses 1-5, wherein the first diverter is oriented at a first angle with respect to a vertical axis.
7. The system of any one of clauses 1-4, wherein the first diverter is horizontally oriented.
8. The system of any one of clauses 1-7, wherein the first diverter is oriented at a first angle with respect to a horizontal axis.
9. The system of any one of clauses 2-8, further comprising a second diverter positioned between the first heat sink and the second heat sink.
10. The system of clause 9, wherein the first diverter is positioned upstream, in the air flow, from the second diverter.
11. The system of clause 9 or 10, wherein the second diverter is configured to direct at least a third portion of the air flow into the first heat sink and to direct at least a fourth portion of the air flow into the second heat sink.
12. The system of any one of clauses 9-11, further comprising a third diverter positioned between the first heat sink and the second heat sink, wherein the second diverter is configured to direct the first portion of the air flow along the first heat sink and the third diverter is configured to direct the second portion of the air flow along the second heat sink.
13. The system of any one of clauses 9-12, wherein the second diverter is longer than the first diverter.
14. The system of clause 1, further comprising a second heat sink thermally coupled to the first heat generating device.
15. The system of clause 14, further comprising a second heat generating device within the housing, a third heat sink thermally coupled to the second heat generating device, and a fourth heat sink thermally coupled to the second heat generating device.
16. The system of clause 14 or 15, wherein the first diverter is configured to also direct at least a second portion of the air flow into the third heat sink.
17. The system of any one of clauses 14 -16, further comprising a second diverter configured to direct at least a third portion of the air flow into the second heat sink.
18. The system of any one of clauses 15 or 17, further comprising a third diverter configured to direct at least a fourth portion of the air flow into the fourth heat sink.
19. The system of clause 16, further comprising a second diverter positioned between the first heat sink and the third heat sink.
20. The system of clause 18 or 19, further comprising a fourth diverter positioned between the first heat sink and the third heat sink.

Obvious modifications and alterations to the described examples are available to those of ordinary skill in the art having the benefits of the present disclosure. The disclosed and undisclosed examples are not intended to limit or restrict the scope or applicability of the inventions conceived of by the Applicants, but rather, in conformity with the patent laws, Applicants intend to fully protect all such modifications and improvements that come within the scope or range of equivalents of the following claims.

## Claims

1. A system comprising:
an electronic equipment housing having a first heat generating device therein;
a fan configured to induce air flow through the housing;
a first heat sink thermally coupled to the first heat generating device; and
a first diverter positioned to direct at least a first portion of the air flow into the first heat sink.

2. The system of claim 1, further comprising a second heat generating device within the housing and a second heat sink thermally coupled to the second heat generating device, and wherein the first diverter is configured to also direct at least a second portion of the air flow into the second heat sink.

3. The system of claim 1 or 2, wherein the first diverter is V-shaped; or optionally
wherein the first diverter has a V-shaped cross-section; or optionally
wherein the first diverter is vertically oriented.

4. The system of any one of claims 1-3, wherein the first diverter is oriented at a first angle with respect to a vertical axis.

5. The system of claim 1 or 2, wherein the first diverter is horizontally oriented.

6. The system of any one of the preceding claims, wherein the first diverter is oriented at a first angle with respect to a horizontal axis.

7. The system of any one of claims 2-6, further comprising a second diverter positioned between the first heat sink and the second heat sink.

8. The system of claim 7, wherein the first diverter is positioned upstream, in the air flow, from the second diverter; or optionally
wherein the second diverter is configured to direct at least a third portion of the air flow into the first heat sink and to direct at least a fourth portion of the air flow into the second heat sink; or optionally
further comprising a third diverter positioned between the first heat sink and the second heat sink, wherein the second diverter is configured to direct the first portion of the air flow along the first heat sink and the third diverter is configured to direct the second portion of the air flow along the second heat sink; or optionally
wherein the second diverter is longer than the first diverter.

9. The system of claim 1, further comprising a second heat sink thermally coupled to the first heat generating device.

10. The system of claim 9, further comprising a second heat generating device within the housing, a third heat sink thermally coupled to the second heat generating device, and a fourth heat sink thermally coupled to the second heat generating device.

11. The system of claim 10, wherein the first diverter is configured to also direct at least a second portion of the air flow into the third heat sink.

12. The system of any one of claims 10-11, further comprising a second diverter configured to direct at least a third portion of the air flow into the second heat sink.

13. The system of any one of claims 10 -12, further comprising a third diverter configured to direct at least a fourth portion of the air flow into the fourth heat sink.

14. The system of claim 11, further comprising a second diverter positioned between the first heat sink and the third heat sink.

15. The system of any one of claims 10-14, further comprising a fourth diverter positioned between the first heat sink and the third heat sink.
